# EUROPÄISCHE PATENTANMELDUNG

(11) **EP 1 365 638 A2**
(43) Veröffentlichungstag der Anmeldung: **26.11.2003**
(21) Anmeldenummer: 03011467.2
(22) Anmeldetag: 20.05.2003
(51) Int. Cl.: H05K 3/24

(54) **Verfahren zum Verbessern der elektrischen Leitfähigkeit und der Korrosions- und Verschleissfestigkeit einer flexiblen Schaltung**

(30) Priorität: 24.05.2002 DE 10223209
(71) Anmelder: Delphi Technologies, Inc., Troy, MI 48007 (US)
(72) Erfinder: Günay, Tarik, 41460 Neuss (DE); Diedrich, Udo, 58256 Ennepetal (DE)
(74) Vertreter: Manitz, Finsterwald & Partner GbR

(57) **Zusammenfassung**

In einem Verfahren zum Verbessern der elektrischen Leitfähigkeit und der Korrosions- und Verschleißfestigkeit einer flexiblen Schaltung wird mindestens ein Anschlussbereich mindestens einer Leiterbahn mit elektrisch leitenden Teilchen selektiv beschichtet.

## Beschreibung

Die Erfindung betrifft ein Verfahren zum Verbessern der elektrischen Leitfähigkeit und der Korrosions- und Verschleißfestigkeit einer flexiblen Schaltung sowie eine flexible Schaltung.

Aufgabe der Erfindung ist es, ein Verfahren zur Metallisierung flexibler Schaltungen anzugeben, mit dem zuverlässige korrosions- und verschleißfeste Kontakte kostengünstig erhalten werden.

Diese Aufgabe wird durch die Merkmale der unabhängigen Ansprüche gelöst.

Vorteilhafte Ausführungsformen der Erfindung sind in der Beschreibung, der Zeichnung und den Unteransprüchen beschrieben.

Die Aufgabe wird insbesondere dadurch gelöst, dass mindestens ein Anschlussbereich mindestens einer Leiterbahn der flexiblen Schaltung mit elektrisch leitenden Teilchen selektiv beschichtet wird. Da lediglich der Anschlussbereich bzw. die Anschlussbereiche der Leiterbahnen der flexiblen Schaltung beschichtet werden, wird Beschichtungsmaterial gespart und gleichzeitig die elektrische Leitfähigkeit und die Korrosions- und Verschleißfestigkeit verbessert.

Die elektrisch leitenden Teilchen können durch eine Schablone geleitet werden, um den Anschlussbereich selektiv zu beschichten. Auf diese Weise wird gewährleistet, dass nur die Anschlussbereiche der flexiblen Schaltung elektrisch leitend beschichtet werden. Zudem wird vermieden, dass eine Schutzfolie, mit der Schaltungsbereiche außerhalb der Anschlussbereiche bedeckt sind, durch den Beschuss mit den leitenden Teilchen angegriffen wird.

Die elektrisch leitenden Teilchen können durch eine Schablone mit einer Mehrzahl von Öffnungen geleitet werden, um eine Mehrzahl von Anschlussbereichen mindestens einer Leiterbahn selektiv zu beschichten. Dadurch können mehrere Anschlussbereiche einer oder mehrerer Leiterbahnen schnell und kostengünstig selektiv, d.h. ohne nicht zu kontaktierende Bereiche der flexiblen Schaltung zu beschichten, mit elektrisch leitenden Teilchen bedeckt werden. Zudem wird ermöglicht, dass die Anschlussbereiche in Form eines miniaturisierten Linienmusters hergestellt werden können.

In einer bevorzugten Ausführungsform kann eine Schablone mit Öffnungen in einer Reihe verwendet werden, um in einer Reihe beabstandet angeordnete Anschlussbereiche selektiv zu beschichten, die Schablone kann über den in einer Reihe angeordneten Anschlussbereichen positioniert werden und eine Relativbewegung zwischen einem Teilchenstrom der elektrisch leitenden Teilchen und der Schablone kann im wesentlichen parallel zu der Reihe der Öffnungen ausgeführt werden.

Dadurch können die Öffnungen der Schablone nacheinander mit einem kontinuierlichen Strom von Teilchen beschossen werden und die in einer Reihe angeordneten Anschlussbereiche können nacheinander beschichtet werden. Ein wiederholtes An- und Ausschalten des Teilchenstroms kann auf diese Weise vermieden werden, da der Teilchenstrom kontinuierlich auf die flexible Schaltung gerichtet werden kann, ohne dabei nicht zu beschichtende Bereiche der Schaltung zu treffen. Zudem wird das Verfahren verkürzt und das Aufbringen einer gleichmäßigen Schicht vereinfacht. So wird durch die Verwendung einer Schablone und eines kontinuierlichen Teilchenstroms elektrisch leitender Teilchen die Metallisierung der flexiblen Schaltung effizienter ausgeführt.

Ferner kann durch Einstellen der Teilchendichte im Teilchenstrom und der Geschwindigkeit, mit der die Relativbewegung zwischen dem Teilchenstrom und der Schablone erfolgt, die Dichte der elektrisch leitenden Teilchen in der Schicht auf den Anschlussbereichen gesteuert werden.

Außerdem ist bei dem erfindungsgemäßen Verfahren ein Erhitzen der flexiblen Schaltung unnötig, so dass auch niedrig schmelzende oder leicht oxidierbare Materialien bei der Herstellung der flexiblen Schaltung verwendet werden können.

Es kann eine Mehrzahl nebeneinander angeordneter flexibler Schaltungen beschichtet werden. Dadurch können die elektrischen Kontakte einer größeren Charge flexibler Schaltungen gleichzeitig und damit effizient und kostengünstig metallisiert werden.

Es kann ein Anschlussbereich am Ende einer flexiblen Leiterbahn beschichtet werden. So können die elektrischen Kontakte am Ende einer Platine, die zur Kontaktierung beispielsweise in ein Motherboard eingeschoben wird, veredelt werden.

Der Anschlussbereich kann durch kinetisches Sprayen elektrisch leitender Teilchen beschichtet werden, d.h. die Technik des kinetischen Sprayens kann zur selektiven Beschichtung einer flexiblen Schaltung eingesetzt werden, um deren elektrische Leitfähigkeit und Korrosions- und Verschleißfestigkeit zu verbessern.

Die elektrisch leitenden Teilchen können in Richtung des Anschlussbereichs, insbesondere auf etwa 300 bis etwa 1000 m/s, beschleunigt werden. Durch die Beschleunigung werden die elektrisch leitenden Teilchen in die Oberfläche der Leiterbahn eingebettet und können im Falle von metallischen Teilchen eine metallische Bindung mit einem metallischen Material der Leiterbahn ausbilden. Zudem wird eine eventuell vorhandene Oxidschicht auf der Leiterbahn durchbrochen, so dass eine ausreichende elektrische Leitfähigkeit gesichert und eine Entfernung der Oxidschicht vor der Metallisierung überflüssig ist.

Die elektrischen leitenden Teilchen können durch Einbringen in einen Gasstrom beschleunigt werden. Dadurch können die elektrisch leitenden Teilchen auf einfache Weise in Richtung der flexiblen Schaltung auf eine Geschwindigkeit beschleunigt werden, die die Ausbildung zuverlässig leitfähiger elektrischer Kontakte möglich macht.

Die elektrisch leitenden Teilchen können in die Oberfläche des Anschlussbereichs eingebettet werden und eine diskontinuierliche Oberfläche oberhalb der Oberfläche der Leiterbahnen bilden. Dies führt zur Ausbildung einer mechanisch festen Verbindung zwischen den leitenden Teilchen und dem Material des Anschlussbereichs. Im Falle der Verwendung von metallischen Materialien entsteht zudem eine metallische Bindung zwischen den leitenden Teilchen und dem Material des Anschlussbereichs. Ferner bietet die diskontinuierliche Oberfläche mindestens einen Kontaktpunkt pro Anschlussbereich. Dadurch werden zuverlässige Kontakte erhalten und zugleich wird die Korrosions- und Verschleißfestigkeit der flexiblen Schaltung an ihren Anschlussbereichen verbessert.

Das Material der elektrisch leitenden Teilchen kann Zinn, Silber, Gold, Platin, eine Legierung davon, eine Mischung davon und/oder eine Zinn/Silber-, eine Zinn/Kupfer- und/oder Zinn/Blei-Legierung umfassen. Insbesondere bei Verwenden der Technik des kinetischen Sprayens ist es nicht nötig, für die Metallisierung im Vergleich zum Material des Anschlussbereichs ein weicheres oder niedriger schmelzendes Material auszuwählen. Der Grund dafür ist die kinetische Energie der Teilchen, die zu einem teilweisen Eindringen der Teilchen in die Oberfläche des Anschlussbereichs führt. Ein Anpressen oder ein Erhitzen der Schicht aus leitenden Teilchen erübrigt sich daher. Infolgedessen können die angegebenen Materialien zusammen mit beliebigen Materialien des Anschlussbereichs zur Erzeugung zuverlässiger elektrischer Kontaktbereiche einer flexiblen Schaltung verwendet werden.

Aus diesem Grund kann das Material der Leiterbahnen Kupfer, Aluminium, Wolfram, Gold und/oder Zinn umfassen.

Die Lösung der Aufgabe erfolgt außerdem durch eine flexible Schaltung mit mindestens einem Anschlussbereich mindestens einer Leiterbahn, der durch ein Verfahren nach einem der vorstehenden Ansprüche erhältlich ist. Infolgedessen kann eine flexible Schaltung einen oder mehrere Anschlussbereiche mit einer zuverlässigen elektrischen Leitfähigkeit und einer ausgeprägten Korrosions- und Verschleißfestigkeit erhalten.

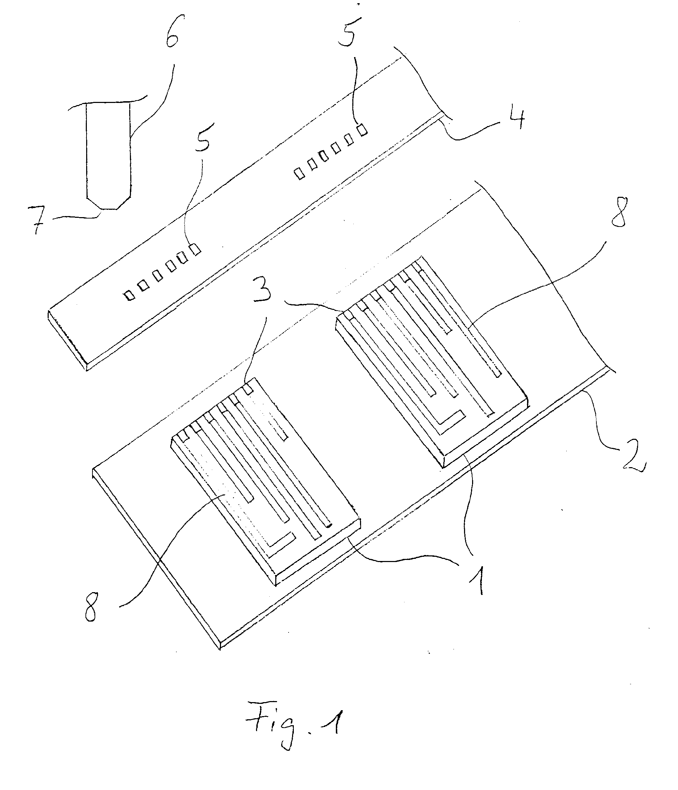

Nachfolgend wird die Erfindung rein beispielhaft unter Bezugnahme auf die beigefügte Zeichnung beschrieben. Es zeigt
- Fig. 1: eine Draufsicht auf eine Anordnung zur Ausführung des erfindungsgemäßen Verfahrens.

Zur Ausführung des erfindungsgemäßen Verfahrens werden rechteckige flexible Schaltungen 1 parallel zueinander in einer Reihe auf einem Rahmen 2 angeordnet. Die flexiblen Schaltungen 1 besitzen Kontaktflächen 3 aus Kupfer, die durch Metallisieren veredelt werden sollen. Jede Kontaktfläche 3 befindet sich an einem Ende einer Leiterbahn 8, die in eine Kunststoffoberfläche der jeweiligen flexiblen Schaltung 1 eingebettet ist. Die Leiterbahnen 8 jeder Schaltung 1 sind derart angeordnet, dass die Kontaktflächen 3 sich in einer Reihe an einem Ende der jeweiligen Schaltung 1 befinden. Beim Anordnen der Schaltungen 1 auf dem Rahmen 2 werden die Kontaktflächen 3 aller flexiblen Schaltungen 1 in einer Reihe ausgerichtet.

Über dem Rahmen 2 wird oberhalb und parallel zu der Reihe der Kontaktflächen 3 der flexiblen Schaltungen 1 eine Schablone 4 in Position gebracht. Die Schablone 4 weist Gruppen von in einer Reihe angeordneten Öffnungen 5 auf. Das Muster und die Abmessungen der Öffnungen 5 jeder Gruppe entsprechen dem Muster und den Abmessungen der Kontaktflächen 3 der zugehörigen, darunter positionierten flexiblen Schaltung 1. Die Schablone 4 ist in Längsrichtung etwa so lang wie der gesamte Rahmen 2 und besitzt senkrecht dazu eine Breite, die etwa 5 mal so groß ist wie die größte Abmessung der Öffnungen 5 in dieser Richtung.

In einer Teilchenkanone 6 wird ein Teilchenstrom aus Zinn-Partikeln in einen fokussierten Luftstrom eingebracht, auf ungefähr 200°C, d.h. auf eine Temperatur unterhalb des Schmelzpunktes von Zinn erwärmt und durch eine Düse am Ausgang 7 der Kanone 6 geleitet. Dabei werden die Teilchen auf ungefähr 300 m/s bis ungefähr 1000 m/s beschleunigt und erhalten kinetische und thermische Energie.

Die Teilchenkanone 6 wird auf die Schablone 4 gerichtet und im wesentlichen parallel zu der Reihe der Öffnungen 5 über der Schablone 4 in deren Längsrichtung bewegt. Auf diese Weise wird ein kontinuierlicher Strom von Zinn-Teilchen durch die einzelnen Öffnungen 5 der Schablone 4 auf die Kontaktflächen 3 der flexiblen Schaltungen 1 geleitet. Auf diese Weise werden die flexiblen Schaltungen im Bereich ihrer Kontaktflächen selektiv beschichtet, so dass eine auf den Restbereichen der flexiblen Schaltung vorhandene Kunststoff-Schutzfolie nicht von den gesprayten Teilchen getroffen wird.

Die auf den Kontaktflächen 3 auftreffenden Zinn-Teilchen durchdringen eine eventuell dort vorhandene Oxidschicht. Sie werden beim Auftreffen auf die Kontaktflächen 3 in deren Oberfläche teilweise eingebettet und bilden eine diskontinuierliche Oberfläche oberhalb der Oberfläche der Kontaktflächen 3. So entsteht eine mechanisch feste Verbindung mit den Kontaktflächen 3 unter Ausbildung einer metallischen Bindung zwischen den Zinn-Teilchen und dem Kupfer der Kontaktflächen. Auf diese Weise wird eine mechanisch stabile, gegen Abrieb und Verschleiß widerstandsfähige, diskontinuierliche Zinn-Oberfläche auf den Anschlussbereichen der flexiblen Schaltungen ausgebildet.

Die so gebildeten Kontakte weisen wegen der metallischen Bindung zwischen den Zinn-Teilchen und dem Kupfer der Kontaktflächen eine hervorragende elektrische Leitfähigkeit auf. Gleichzeitig sind die Kontakte der flexiblen Schaltungen 1 aufgrund des Zinn-Materials der diskontinuierlichen Oberfläche gegen Korrosion geschützt.

Durch ihre Verschleißfestigkeit sind die erfindungsgemäß hergestellten Anschlussbereiche für flexible Schaltungen geeignet, deren Kontaktflächen häufig kontaktiert werden. Zudem sind aufgrund der Verwendung einer Schablone, deren Öffnungen nur durch kleine Abstände getrennt sind, fein strukturierte Anschlussbereiche herstellbar, deren Einzelkontakte so gering beabstandet sind, dass auch stark miniaturisierte Leiterbahnen einzeln kontaktiert werden können.

Durch das erfindungsgemäße Verfahren ist ferner eine flexible Schaltung mit Anschlussbereichen für Leiterbahnen erhältlich, die infolge der diskontinuierlichen Zinn-Oberfläche eine Vielzahl von Kontaktpunkten besitzen, die mechanisch stabil sind und zugleich einen nur geringen Kontaktwiderstand aufweisen.

Des weiteren kann als das Material, mit dem die Kontaktflächen der flexiblen Schaltungen veredelt werden, auch ein Metall bzw. ein elektrisch leitendes Material gewählt werden, das härter oder höher schmelzend ist als das Material der Leiterbahnen. Dies ist eine Folge der Technik des kinetischen Sprühens, bei dem die Teilchen auf die Leiterbahnen beschleunigt und in die Oberfläche der Leiterbahnen unter Ausbildung einer mechanisch festen Verbindung eingebettet werden. Dadurch erübrigt sich ein Anpressen des Veredelungsmaterials. Auch ein Erhitzen der flexiblen Schaltung bei ihrer Metallisierung ist überflüssig, so dass niedrig schmelzende Bestandteile der flexiblen Schaltung bei der Veredelung der Anschlussflächen nicht angegriffen oder beeinträchtigt werden.

Das erfindungsgemäße Verfahren führt durch eine selektive Beschichtung der Anschlussbereiche von Leiterbahnen einer flexiblen Schaltung nicht nur zur Einsparung von Beschichtungsmaterial, sondern auch zu einer außerordentlichen Verbesserung der elektrischen Leitfähigkeit und der Korrosions- und Verschleißfestigkeit einer flexiblen Schaltung an ihren Anschlussbereichen.

### Bezugszeichenliste

- 1: flexible Schaltung
- 2: Rahmen
- 3: Kontaktfläche
- 4: Schablone
- 5: Öffnung
- 6: Teilchenkanone
- 7: Ausgang
- 8: Leiterbahn

## Patentansprüche

1. Verfahren zum Verbessern der elektrischen Leitfähigkeit und der Korrosions- und Verschleißfestigkeit einer flexiblen Schaltung, bei dem
mindestens ein Anschlussbereich mindestens einer Leiterbahn mit elektrisch leitenden Teilchen selektiv beschichtet wird.

2. Verfahren nach Anspruch 1, bei dem
die elektrisch leitenden Teilchen durch eine Schablone geleitet werden, um den Anschlussbereich selektiv zu beschichten.

3. Verfahren nach einem der vorstehenden Ansprüche, bei dem
die elektrisch leitenden Teilchen durch eine Schablone mit einer Mehrzahl von Öffnungen geleitet werden, um eine Mehrzahl von Anschlussbereichen mindestens einer Leiterbahn selektiv zu beschichten.

4. Verfahren nach einem der vorstehenden Ansprüche, bei dem
eine Schablone mit Öffnungen in einer Reihe verwendet wird, um in einer Reihe beabstandet angeordnete Anschlussbereiche selektiv zu beschichten,
die Schablone über den in einer Reihe angeordneten Anschlussbereichen positioniert wird,
und
im wesentlichen parallel zu der Reihe der Öffnungen eine Relativbewegung zwischen einem Teilchenstrom der elektrisch leitenden Teilchen und der Schablone ausgeführt wird.

5. Verfahren nach Anspruch 4, bei dem
eine Mehrzahl nebeneinander angeordneter flexibler Schaltungen beschichtet wird.

6. Verfahren nach einem der vorstehenden Ansprüche, bei dem ein Anschlussbereich am Ende einer flexiblen Leiterbahn beschichtet wird.

7. Verfahren nach einem der vorstehenden Ansprüche, bei dem
der Anschlussbereich durch kinetisches Sprayen elektrisch leitender Teilchen beschichtet wird.

8. Verfahren nach einem der vorstehenden Ansprüche, bei dem die elektrisch leitenden Teilchen in Richtung des Anschlussbereichs, insbesondere auf etwa 300 bis etwa 1000 m/s, beschleunigt werden.

9. Verfahren nach einem der vorstehenden Ansprüche, bei dem die elektrisch leitenden Teilchen durch Einbringen in einen Gasstrom beschleunigt werden.

10. Verfahren nach einem der vorstehenden Ansprüche, bei dem die elektrisch leitenden Teilchen in die Oberfläche des Anschlussbereichs eingebettet werden und eine diskontinuierliche Oberfläche oberhalb der Oberfläche der Leiterbahnen bilden.

11. Verfahren nach einem der vorstehenden Ansprüche, bei dem das Material der elektrisch leitenden Teilchen Zinn, Silber, Gold, Platin, eine Legierung davon, eine Mischung davon und/oder eine Zinn/Silber-, eine Zinn/Kupfer- und/oder eine Zinn/Blei-Legierung umfasst.

12. Verfahren nach einem der vorstehenden Ansprüche, bei dem das Material der Leiterbahnen Kupfer, Aluminium, Wolfram, Gold und/oder Zinn umfasst.

13. Flexible Schaltung mit mindestens einem Anschlussbereich mindestens einer Leiterbahn, der durch ein Verfahren nach einem der vorstehenden Ansprüche erhältlich ist.
